Europäisches Patentamt

(19) European Patent Office

Office européen des brevets

(11) Veröffentlichungsnummer: **0 007 088**
**B1**

(12) **EUROPÄISCHE PATENTSCHRIFT**

(45) Veröffentlichungstag der Patentschrift:
**10.02.82**

(21) Anmeldenummer: **79102354.2**

(22) Anmeldetag: **09.07.79**

(51) Int. Cl.³: **H 05 K 1/11,** H 01 H 63/33,
H 01 R 9/26, H 01 R 17/18,
H 02 G 3/08

(54) **Einrichtung zur Betätigung von Kontakten.**

(30) Priorität: **18.07.78 AT 5191/78**

(43) Veröffentlichungstag der Anmeldung:
**23.01.80 Patentblatt 80/2**

(45) Bekanntmachung des Hinweises auf die Patenterteilung:
**10.02.82 Patentblatt 82/6**

(84) Benannte Vertragsstaaten:
**CH DE FR**

(56) Entgegenhaltungen:
**DE-A-1 490 390**
**DE-A-2 025 889**
**DE-A1-2 403 425**
**DE-B-2 146 939**
**US-A-3 631 374**
**US-A-4 084 870**
**US-A-4 130 328**

(73) Patentinhaber: **SIEMENS AKTIENGESELLSCHAFT Berlin
und München, Postfach 22 02 61, D-8000 München 22 (DE)**

(72) Erfinder: **Huber, August, Hauptstrasse 128,
A-3420 Kritzendorf (AT)**

## Einrichtung zur Betätigung von Kontakten

Die Erfindung betrifft eine Einrichtung zur Betätigung von Kontakten, insbesondere Codierkontakten, welche in einem mit einer plombierbaren Gehäusekappe versehenen elektronischen Gerät mit einem Klemmenblock, vorzugsweise einem Rundsteuerempfänger, angeordnet sind, wobei der Klemmenblock eine von der Gehäusekappe unabhängige gleichfalls plombierbare Klemmenblockabdeckung aufweist. Eine derartige Einrichtung ist beispielsweise bei im Verkehr befindlichen Rundsteuerempfängern bekannt. Rundsteuerempfänger dienen dazu, über das Stromversorgungsnetz übertragene tonfrequente Impulstelegramme auszuwerten und in eine Schalthandlung, beispielsweise das Einschalten der Strassenbeleuchtung, umzusetzen. Zum Anschluss an das Netz und zur Verbindung mit der zu schaltenden Einheit, also beispielsweise der Strassenbeleuchtung, weist der Rundsteuerempfänger einen Klemmenblock mit einer plombierbaren Klemmenblockabdeckung auf. Die restlichen elektronischen Funktionselemente des Rundsteuerempfängers, wie Eingangskreis, Decoder und vom Decoder gesteuerte Schalter, sind durch eine ebenfalls plombierbare Gehäusekappe abgedeckt. Um ein selektives Ansprechen einzelner Rundsteuerempfänger oder Gruppen von Rundsteuerempfängern zu ermöglichen, wird bei der Installation dieser Rundsteuerempfänger eine bestimmte Auswahl eines Satzes von decodernahen Codierkontakten geschlossen. Hierzu ist jedoch die Gehäusekappe abzunehmen, wodurch die Gefahr der Verstellung von Justierungen und der Beschädigung von hochintegrierten Schaltungen durch Berührung mit elektrisch aufgeladenen Händen oder Werkzeugen besteht. Diese Problematik ist nicht auf Rundsteuerempfänger beschränkt.

Aus der DE-OS-2 403 425 ist eine Umschaltvorrichtung bekannt, bei der mehrere als Klemmstellen ausgebildete Kontakte, die zunächst gegeneinander isoliert sind, durch ein hindurchsteckbares Verbindungsorgan miteinander elektrisch leitend verbunden werden können. Als Verbindungsorgan dient ein gerader Stift, der elektrisch isolierte Abschnitte kleineren Durchmessers zum Auslassen von Klemmstellen und zur im Betrieb berührungssicheren Anzeige der Schaltstellung aufweisen kann. Die Vielzahl der Klemmstellen kann durch eine vorgelagerte, mit Bohrungen versehenen Abdeckplatte abgedeckt sein, wobei die Bohrungen zu den Klemmstellen fluchtend angeordnet sind.

Der Erfindung liegt die Aufgabe zugrunde, eine Einrichtung zur Betätigung von Kontakten der eingangs genannten Art anzugeben, bei der bei Kontaktbetätigung eine Dejustierung oder Beschädigung des elektronischen Geräts ausgeschlossen ist.

Die Aufgabe wird erfindungsgemäss dadurch gelöst, dass nach Abnahme der Klemmenblockabdeckung zugängliche Betätigungselemente verschiebbar in Form stabförmiger Isolierstoffkörper für die unter der plombierbaren Gehäusekappe angeordneten Kontakte in Führungskanälen des Klemmenblocks angeordnet sind. Damit ist es zur Betätigung der Kontakte nicht mehr erforderlich, die Gehäusekappe abzunehmen und die Plombierung zu lösen. Die Gefahr der Dejustierung oder Beschädigung des hinter der Gehäusekappe befindlichen elektronischen Gerätes ist damit ausgeschlossen. Der Klemmenblock erhält eine zusätzliche Funktion als Führungselement für die verschiebbar in Führungskanälen angeordneten stabförmigen Isolierstoffkörper. Damit wird ein eigenes Führungselement für die verschiebbaren Isolierstoffkörper nicht erforderlich. Dies verringert den fertigungstechnischen Aufwand und begünstigt die Raumökonomie des Aufbaus. Darüber hinaus wird eine hohe Montagefreundlichkeit erreicht, da zum Anschliessen des Klemmenblocks ohnehin die plombierbare Klemmenblockabdeckung abgenommen werden muss und dabei gleichzeitig die gewünschte Betätigung der Kontakte über die Verschiebung der zugehörigen stabförmigen Isolierstoffkörper erfolgen kann.

In einer vorteilhaften Ausführungsform tragen die Betätigungselemente an einem Ende einen oder mehrere Gegenkontaktstifte, die mit den im Inneren des Gerätes angeordneten Kontakten zusammenwirken. Damit wird eine hohe Kontaktsicherheit erreicht.

Es ist vorteilhaft, wenn die stabförmigen Isolierstoffkörper mit nachgiebig angeordneten, der Einrastung im Klemmenblock dienenden Wülsten versehen sind. Damit erfolgt eine zuverlässige Festhaltung der stabförmigen Isolierstoffkörper in ihrer Endlage.

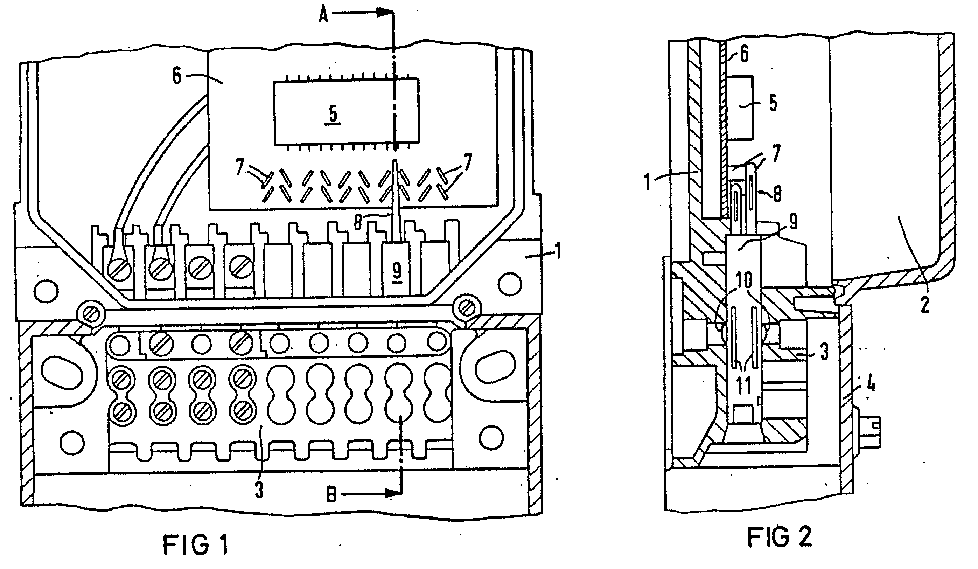

Ein Ausführungsbeispiel der Erfindung ist in der Zeichnung dargestellt. Fig. 1 zeigt einen Rundsteuerempfänger in Ansicht von vorne, von dem in Fig. 2 ein Schnitt entlang der Linie A - B dargestellt ist.

Der dargestellte Rundsteuerempfänger besitzt einen Basisteil 1, der die Einzelteile trägt und eine Gehäusekappe 2, die nur in Fig. 2 zu sehen ist. Zur Herstellung von Verbindungen zwischen dem Netz und internen Stromkreisen dienen Klemmen, die an einem Klemmenblock 3 angeordnet sind, der zur Hälfte von der Gehäusekappe 2 abgedeckt wird; für den freien Teil des Klemmenblockes 3 ist eine eigene Klemmenblockabdeckung 4 vorgesehen, die nur in Fig. 2 dargestellt ist. Sowohl die Gehäusekappe 2 als auch die Klemmenblockabdeckung 4 sind mit je einer eigenen Plombe gesichert. Von den im Inneren des Gehäuses vorgesehenen Teilen ist ein elektronischer Bauteil 5 dargestellt, der auf einer bedruckten Leiterplatte 6 montiert ist. Im speziellen dient der elektronische Bauteil 5 als Decoder der Entschlüsselung von Tonfrequenz-Impulstelegrammen und ist entsprechend zu codieren. Hierzu dient ein Satz von Codierkontakten 7, von denen zehn Paare dargestellt sind, die in fünf Gruppen zu je zwei Paaren angeordnet sind. Durch Herstellung einer leitenden Verbindung zwischen den beiden Kontakten 7 eines Kontaktpaares mittels eines Gegenkontaktstückes 8 wird je ein Befehl eingegeben. Die Anordnung der Kontaktpaare ist so getroffen, dass das eine Kontaktpaar jeder Gruppe dem Einschaltbefehl und das zweite Kontaktpaar dem zugehörigen Ausschaltbefehl zugeordnet ist. Mit Hilfe der dargestellten Anordnung lassen sich somit insgesamt fünf Doppelbefehle eingeben, wozu jeweils zwei Gegenkontaktstücke 8 vorgesehen sind, die gemeinsam an einem Steckerstift 9 angebracht sind. Im allgemeinen wird ein Rundsteuerempfänger auf nur einen Doppelbefehl eingestellt und demgemäss ist in der Zeichnung auch nur ein einziger, in der Linie A - B liegender Steckerstift 9 dargestellt.

Die Steckerstifte 9 werden von aussen durch Führungskanäle des Klemmblockes 3 in das Gehäuse eingesteckt, derart, dass am Ende der Einsteckbewegung die Gegenkontaktstücke 8 mit den entsprechenden Kontaktpaaren der Codierkontakte 7 in festem Kontakt stehen. Die Voraussetzung dafür ist, dass die Kontaktstücke 7 des elektronischen Gerätes jeweils in der Verlängerung des zugeordneten Führungskanals angeordnet sind.

Bei der Codierung des Rundsteuerempfängers braucht das die elektronischen Bauteile enthaltende Gehäuse nicht geöffnet, d.h. die Gehäusekappe 2 nicht entfernt zu werden. Es genügt vielmehr nur die Wegnahme der Klemmenblockabdeckung 4, die den von aussen erreichbaren Teil des Klemmenblockes 3 schützt. Nach dem Einstecken des Steckerstiftes 9 in den Klemmenblock 3 wird er in diesem mittels nachgiebig angeordneter Wülste 10 festgehalten, die in entsprechende Ausnehmungen des Klemmenblockes 3 einrasten. Die Nachgiebigkeit der Wülste 10 wird mit Hilfe von Schlitzen 11 unterhalb der Wülste 10 erzielt.

Die Erfindung ist nicht auf Kontaktanordnungen der dargestellten Art beschränkt, bei denen nämlich ein Teil der Kontaktstücke fest am Gerät und der andere Teil am Betätigungselement befestigt ist. Die Erfindung eignet sich beispielsweise auch für am Gerät angeordnete Zungenkontakte, deren Kontaktzunge etwa durch ein zur Gänze aus Isoliermaterial bestehendes Betätigungselement bewegt werden kann.

## Patentansprüche

1. Einrichtung zur Betätigung von Kontakten, insbesondere Codierkontakten, welche in einem mit einer plombierbaren Gehäusekappe (2) versehenen elektronischen Gerät mit einem Klemmenblock (3), vorzugsweise einem Rundsteuerempfänger, angeordnet sind, wobei der Klemmenblock (3) eine von der Gehäusekappe (2) unabhängige gleichfalls plombierbare Klemmenblockabdeckung (4) aufweist, dadurch gekennzeichnet, das nach Abnahme der Klemmenblockabdeckung (4) zugängliche Betätigungselemente verschiebbar in Form stabförmiger Isolierstoffkörper (9) für die unter der plombierbaren Gehäusekappe (2) angeordneten Kontakte (7) in Führungskanälen des Klemmenblocks (3) angeordnet sind.

2. Einrichtung nach Anspruch 1, dadurch gekennzeichnet, dass die Betätigungselemente an einem Ende einen oder mehrere Gegenkontaktstifte (8) tragen, die mit den im Inneren des Gerätes angeordneten Kontakten (7) zusammenwirken.

3. Einrichtung nach Anspruch 1 oder 2, dadurch gekennzeichnet, dass die stabförmigen Isolierstoffkörper (9) mit nachgiebig angeordneten, der Einrastung im Klemmenblock (3) dienenden Wülsten (10) versehen sind.

## Claims

1. An arrangement for operating contacts, in particular coding contacts, which are arranged in an electronic device which has a sealable casing cap (2) and is provided with a terminal block (3), preferably a central control receiver, wherein the terminal block (3) is provided with a terminal block cover (4) which can also be sealed and which is independent of the casing cap (2), characterised in that operating elements for the contacts (7) which are arranged under the sealable casing cap (2), which elements are accessible after the removal of the terminal block cover (4), formed by rod-shaped bodies of insulating material which are movably arranged in guide channels in the terminal block (3).

2. An arrangement as claimed in claim 1, characterised in that the operating elements are provided at one end with one or more counter-contact pins (8), which co-operate with the contacts (7) arranged in the interior of the casing.

3. An arrangement as claimed in claim 1 or claim 2, characterised in that the rod-shaped bodies of insulating material (9) are provided with flexibly arranged protuberances (10) which serve to engage with the terminal block (3).

## Revendications

1. Installation pour la commande de contacts, plus particulièrement de contacts de codage qui sont disposés dans un appareil électronique pourvu d'un capot de boîtier (2) plombable et comportant un bloc à bornes (3), de préférence dans un récepteur de télécommande centralisée, ledit bloc à bornes (3) comportant un couvre-bornes (4) indépendant du capot (2) et pouvant également être plombé, caractérisée par le fait qu'après l'enlèvement du couvre-bornes (4), des éléments de commande accessibles sont disposés de façon à être déplaçables, dans des canaux de guidage du bloc à bornes (3), sous la forme de corps (5) en un matériau isolant, à l'allure de barreaux, pour les contacts disposés sous le capot plombable (2) du boîtier.

2. Installation selon la revendication 1, caractérisée par le fait que les éléments de commande portent, à une extrémité, une ou plusieurs fiches de contacts antagonistes (8) qui coagissent avec les contacts (7) prévus à l'intérieur de l'appareil.

3. Installation selon la revendication 1 ou 2, caractérisée par le fait que les corps (9) en un matériau isolant et à l'allure de barreaux sont pourvus de protubérances (10) agencées élastiquement et servant à l'encliquetage dans le bloc à bornes (3).

FIG 1

FIG 2

0 007 088